Europäisches Patentamt

European Patent Office

Office européen des brevets

(19)

(11) Publication number: 0 287 681

A1

(12) **EUROPEAN PATENT APPLICATION**
published in accordance with Art. 158(3) EPC

(21) Application number: 87906790.8

(22) Date of filing: 19.10.87

Data of the international application taken as a basis:

(86) International application number:
PCT/JP87/00801

(87) International publication number:
WO88/02978 (21.04.88 88/09)

(51) Int. Cl.³: H 05 K 3/46

(30) Priority: 20.10.86 JP 249191/86

(43) Date of publication of application:
26.10.88 Bulletin 88/43

(84) Designated Contracting States:
DE FR GB IT

(71) Applicant: FANUC LTD
3580, Shibokusa Aza-Komanba Oshino-mura
Minamitsuru-gun Yamanashi 401-05(JP)

(72) Inventor: FUJIOKA, Yoshiki
Greentown 3-306 1293-10, Tatsuno 3-chome
Higashiyamato-shi Tokyo 189(JP)

(72) Inventor: SHINOHARA, Tatsuo
Dai 2 Nomuracorpo 202 35-13, Maehara-cho 3-chome
Koganei-shi Tokyo 184(JP)

(74) Representative: Billington, Lawrence Emlyn et al,
HASELTINE LAKE & CO Hazlitt House 28 Southampton
Buildings Chancery Lane
London WC2A 1AT(GB)

(54) MULTI-LAYER PRINTED CIRCUIT BOARD AND A METHOD OF FABRICATING THE SAME.

(57) In a multi-layer printed circuit board, a predetermined circuit pattern is formed as a conductive layer ($b_1$) using a copper foil having a standard thickness, the above conductive layer is laminated (11) on the surface of an insulating layer ($C_1$, the conductive layers having the same circuit pattern and the insulating layers are provided alternatingly in a plurality of stages (11, 12, 13), and the conductive layers are connected together in parallel via a through-hole (T), permitting a large-current control element to be connected thereto.

Fig. 2

EP 0 287 681 A1

DESCRIPTION

MULTILAYER PRINTED CIRCUIT BOARD, AND

METHOD OF MANUFACTURING SAME

## Technical Field

This invention relates to a multilayer printed circuit board used in electrically connecting high-current power components, and to a method of manufacturing such a circuit board.

## Background Art

A printed circuit technique long used in a variety of control systems is to form patterns of an electrically conductive layer on both sides of a printed board comprising an insulator, and interconnect electrical components such as coils or control elements, which are arranged on the printed circuit board, by the conductive layers.

Fig. 4 illustrates the sectional structure of one example of such a printed circuit board. In Fig. 4, both sides of a printed board 1 which uses glass epoxy or the like are provided with electrically conductive layers 2 each comprising a copper foil formed into a predetermined pattern. The two elecrically conductive layers 2, 2 are connected by a through-hole 3 extending from the inner peripheral surface of a hole passing through both sides of the printed board 1 to the peripheral portions of the hole on the board. This allows prescribed circuit operations to take place.

In a printed circuit board constructed in this manner, the copper foil forming the conductive layers 2 has a standard thickness of 35 μm or 760 μm. In a manufacturing process which relies upon vapor deposition or etching, the machinery is adjusted so that a copper foil having either of these thicknesses will be formed. The reason for this is economical. That is, when the conductive layer 2 of a predetermined pattern is etched from a thick copper foil, material (copper) is used wastefully. Accordingly, in an ordinary printed circuit board, there is a limitation upon copper foil thickness. Therefore, when electrical parts are connected using a printed circuit board of limited area, the current capacity is limited because of the thermal capacity of the printed board.

In recent years, however, power control elements such as transistors and thyristors having a high current capacity have come into wider practical use, and printed circuit boards with a high current capacity are needed in order to connect these high-capacity control elements. Nevertheless, printed circuit boards which effectively satisfy this requirement have not been developed.

Disclosure of the Invention

The present invention has been devised in order to solve the aforementioned problem and its object is to provide a multilayer printed circuit board of a large current capacity using an existing printed circuit board manufacturing apparatus, as well as a method of manufacturing such a circuit board.

In accordance with the present invention, there is provided a multilayer printed circuit board comprising a plurality of printed boards on which identical circuit patterns are formed by electrically conductive layers of a standard thickness, holes provided in the electrically conductive layers of these printed boards at corresponding positions, and connecting means for connecting each of the electrically conductive layers in parallel at the inner peripheral surfaces of the holes when the electrically conductive layers and the printed boards on which the layers are formed are alternately superimposed. There is also provided a method of manufacturing a multilayer printed circuit board comprising the steps of forming a predetermined circuit pattern on and a hole in a printed board by an electrically conductive layer of a standard thickness, superimposing a plurality of the printed boards, connecting the electrically conductive layers in parallel by a through-hole formed in the holes, and arranging a high-current control element on an uppermost surface of the printed circuit boards at a predetermined position.

Thus, in accordance with the multilayer printed circuit board and manufacturing method of the present invention, a plurality of electrically conductive layers on which predetermined circuit boards are formed by copper foils of a standard thickness and a plurality

of insulating layers constituting the printed boards are alternately superimposed, and the electrically conductive layers are connected in parallel by a through-hole to connect high-current control elements, e.g. power portions such as transistors or thyristors. Accordingly, a printed circuit board having a large current capacity can be obtained using an existing printed circuit board manufacturing apparatus.

Brief Description of the Drawings

Fig. 1 is a schematic structural view of the present invention, Figs. 2(a), (b) and Fig. 3 are structural views of an embodiment of the invention, and Fig. 4 is a structural view of an example of the prior art.

Best Mode for Carrying Out the Invention

An embodiment of the present invention will now be described in detail with reference to the drawings.

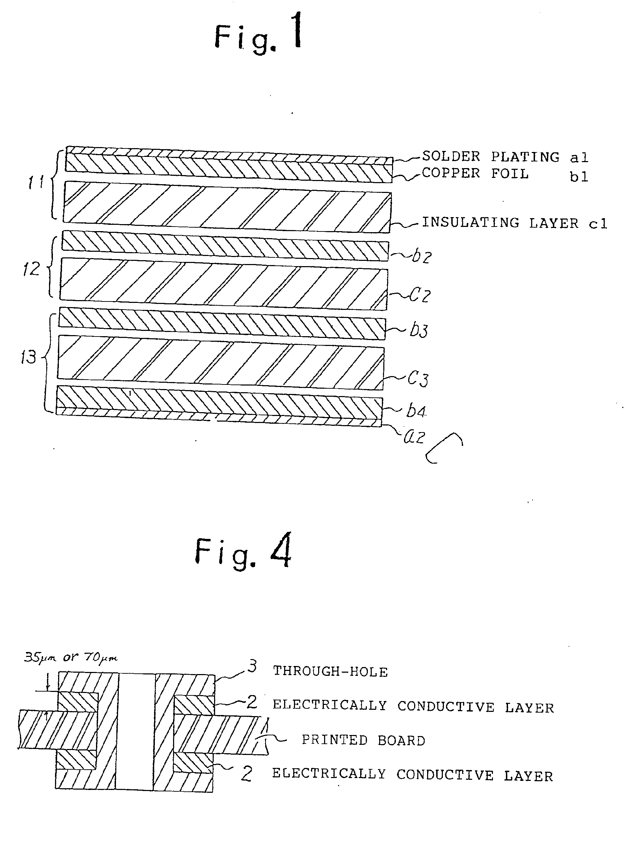

Fig. 1 is a sectional view illustrating, in exploded form, the structure of a multilayer printed circuit board according to the invention. In Fig. 1, an electrically conductive layer on a board 11 comprising a copper foil $b_1$ of a standard thickness formed into a predetermined circuit pattern has solder plating $a_1$ provided on the surface thereof. The board 11 comprises an insulating layer $c_1$ which uses glass epoxy or the like. Copper foils $b_2$, $b_3$ similar to the copper foil $b_1$ are formed in identical circuit patterns on boards 12, 13. In other words, insulating layers

$c_1$, $c_2$, $c_3$, the foil $b_1$ and copper foils $b_2$, $b_3$ formed in circuit patterns identical with that of the copper foil $b_1$ are alternately superimposed, and a copper foil $b_4$ provided with solder plating $a_2$ is formed on the bottom side of the insulating layer $c_3$ in a circuit pattern identical with that of the foil $b_1$. The insulating layer $c_1$, copper foil $b_2$, insulating layer $c_2$ and copper foil $b_3$ are joined by a bonding agent to construct an integrated, laminated multilayer printed circuit board.

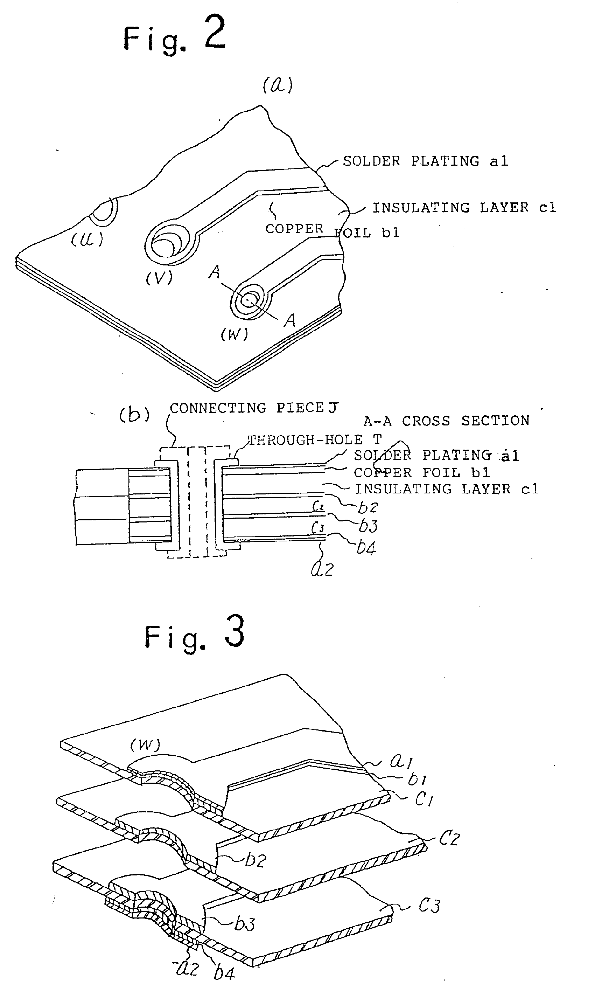

Fig. 2(a) is a schematic explanatory view illustrating a portion of a circuit board using the multilayer printed circuit board of the foregoing embodiment. In this embodiment, the circuit pattern is that for a main power supply circuit to be connected to three-phase power (u), (v), (w). Fig. 2(b) is a sectional view taken along line A-A.

Fig. 3 is a perspective view illustrating a (w)-phase circuit pattern partially broken away.

The electrically conductive layers comprising the solder platings $a_1$, $a_2$ and copper foils $b_1$, $b_2$, $b_3$ are connected in parallel by a through-hole T, as shown. Current capacity can be increased, without enlarging the surface of the wiring patterns, by the plurality of electrically conductive layers formed to have a standard thickness. This makes it possible to form circuits that deliver current to power transistors and the like. A connecting piece J is used to strengthen

-6-

the bond among the multilayer printed boards and to maintain the connection between the conductors. The connecting piece J can be deleted if desired.

The multilayer printed circuit board of the present invention is formed in the following manner: The thickness of the copper foils is made a standard thickness of 70 μm, and the thickness of the solder plating provided on both surfaces of the copper foil is made 30 μm. The thickness of the insulating layers is made 300 μm. Four layers of the copper foil and three layers of the insulator are superimposed to form the laminated structure. The through-hole is formed by electrolytic plating of 35 μm or 75 μm.

Thus is obtained a circuit board connecting power components such as transistors or thyristors. Accordingly, a multilayer printed circuit board having a large current capacity can be obtained using an existing printed circuit board manufacturing apparatus.

Though an embodiment of the present invention has been described, the invention is not limited thereto but can be modified in various ways without departing from the scope of the claims.

Industrial Applicability

The multilayer printed circuit board and the method of manufacturing the same in accordance with the present invention are used in order to connect power control elements having a large current capacity, such as transistors or thyristors.

CLAIMS:

1.   A multilayer printed circuit board comprising:

a plurality of printed boards on which identical circuit patterns are formed by electrically conductive layers of a standard thickness;

holes provided in the electrically conductive layers of these printed boards at corresponding positions; and

connecting means for connecting each of the electrically conductive layers in parallel at inner peripheral surfaces of said holes when said electrically conductive layers and the printed boards on which said layers are formed are alternately superimposed.

2.   A multilayer printed circuit board and a method of manufacturing the same according to claim 1, characterized in that said electrically conductive layers are copper foils.

3.   A multilayer printed circuit board and a method of manufacturing the same according to claim 1, characterized in that said printed boards are a glass epoxy resin.

4.   A method of manufacturing a multilayer printed circuit board comprising the steps of:

forming a predetermined circuit pattern on and a hole in a printed board by an electrically conductive layer of a standard thickness;

superimposing a plurality of the printed boards;

-8-

connecting the electrically conductive layers in parallel by a through-hole formed in said holes; and

arranging a high-current control element on an uppermost surface of said printed circuit boards at a predetermined position.

5. A multilayer printed circuit board and a method of manufacturing the same according to claim 4, characterized in that a solder plating layer is formed on a circuit pattern corresponding to an outer surface of the superimposed printed boards.

6. A multilayer printed circuit board and a method of manufacturing the same according to claim 4, characterized in that said through-hole is formed by electrolytic plating.

# Fig. 1

SOLDER PLATING a1
COPPER FOIL b1
INSULATING LAYER c1

11
12
13

b2
c2
b3
c3
b4
a2

# Fig. 4

35μm or 70μm

3 THROUGH-HOLE
2 ELECTRICALLY CONDUCTIVE LAYER
PRINTED BOARD
2 ELECTRICALLY CONDUCTIVE LAYER

# Fig. 2

(a)

SOLDER PLATING a1

INSULATING LAYER c1

COPPER FOIL b1

(U)

(V)

A

A

(W)

(b) CONNECTING PIECE J

A-A CROSS SECTION

THROUGH-HOLE T

SOLDER PLATING a1

COPPER FOIL b1

INSULATING LAYER c1

$c_2$

$b2$

$c_3$

$b3$

$b4$

$a2$

# Fig. 3

(W)

$a_1$

$b_1$

$c_1$

$c_2$

$b2$

$c_3$

$b3$

$a2$ $b4$

# INTERNATIONAL SEARCH REPORT

0287681

International Application No  PCT/JP87/00801

## I. CLASSIFICATION OF SUBJECT MATTER (if several classification symbols apply, indicate all) 3

According to International Patent Classification (IPC) or to both National Classification and IPC

Int.Cl$^4$     H05K3/46

## II. FIELDS SEARCHED

Minimum Documentation Searched 4

| Classification System | Classification Symbols |
|---|---|
| IPC | H05K3/46 |

Documentation Searched other than Minimum Documentation
to the Extent that such Documents are Included in the Fields Searched 5

Kokai Jitsuyo Shinan Koho          1971 - 1986

## III. DOCUMENTS CONSIDERED TO BE RELEVANT 14

| Category * | Citation of Document, 16 with indication, where appropriate, of the relevant passages 17 | Relevant to Claim No. 18 |
|---|---|---|
| A | JP, U, 61-27270 (Mitsubishi Electric Corporation) 18 February 1986 (18. 02. 86) (Family: none) | 1 |

* Special categories of cited documents: 15

"A"  document defining the general state of the art which is not considered to be of particular relevance

"E"  earlier document but published on or after the international filing date

"L"  document which may throw doubts on priority claim(s) or which is cited to establish the publication date of another citation or other special reason (as specified)

"O"  document referring to an oral disclosure. use. exhibition or other means

"P"  document published prior to the international filing date but later than the priority date claimed

"T"  later document published after the international filing date or priority date and not in conflict with the application but cited to understand the principle or theory underlying the invention

"X"  document of particular relevance; the claimed invention cannot be considered novel or cannot be considered to involve an inventive step

"Y"  document of particular relevance; the claimed invention cannot be considered to involve an inventive step when the document is combined with one or more other such documents, such combination being obvious to a person skilled in the art

"&"  document member of the same patent family

## IV. CERTIFICATION

| Date of the Actual Completion of the International Search 3 | Date of Mailing of this International Search Report 2 |
|---|---|
| December 21, 1987 (21.12.87) | January 18, 1988 (18.01.88) |
| International Searching Authority 1 | Signature of Authorized Officer 20 |
| Japanese Patent Office | |

Form PCT/ISA/210 (second sheet) (October 1977)